# EUROPÄISCHE PATENTSCHRIFT

(11) **EP 2 719 000 B1**
(45) Veröffentlichungstag und Bekanntmachung des Hinweises auf die Patenterteilung: **01.01.2020**
(21) Anmeldenummer: 12725745.9
(22) Anmeldetag: 04.06.2012
(51) Int. Cl.: H01M 2/34, H01M 10/44, H01M 10/48, H01M 10/42, B60L 3/00, G01R 31/367

(54) **VERFAHREN ZUR ERKENNUNG EINER AUSLÖSUNG EINER SICHERHEITSEINRICHTUNG**
METHOD FOR DETECTING A TRIGGERING OF A SECURITY DEVICE
PROCÉDÉ SERVANT À DÉTECTER UN DÉCLENCHEMENT D'UN DISPOSITIF DE SÉCURITÉ

(30) Priorität: 09.06.2011 DE 102011077311
(43) Veröffentlichungstag der Anmeldung: 16.04.2014
(73) Patentinhaber: Robert Bosch GmbH, 70442 Stuttgart (DE); Samsung SDI Co., Ltd., Yongin-si, Gyeonggi-do 446-577 (KR)
(72) Erfinder: FINK, Holger, 70567 Stuttgart (DE)
(74) Vertreter: Bee, Joachim
(86) Internationale Anmeldenummer: PCT/EP2012/060463
(87) Internationale Veröffentlichungsnummer: WO 2012/168169

(56) Entgegenhaltungen:
- DE-A1-102008 010 971
- DE-A1-102009 040 146
- DE-A1-102010 045 904
- DE-T2- 69 411 232
- US-A1- 2010 185 405

## Beschreibung

Die vorliegende Erfindung betrifft ein Verfahren zur Erkennung einer Auslösung einer Sicherheitseinrichtung, welche einer Batteriezelle zugeordnet ist, sowie eine Batteriemanagementeinheit, in welcher das erfindungsgemäße Verfahren ausführbar ist.

### Stand der Technik

Batteriesysteme umfassen wiederaufladbare elektrische Energiespeicher, die einen breiten Einsatz in tragbaren Konsumgeräten und anderen Anwendungen finden, wie beispielsweise in teilweise oder ausschließlich elektrisch betriebenen Fahrzeugen. In automobilen Anwendungen gelten Batteriesysteme und insbesondere Lithium-Ionen-Batteriesysteme als Schlüsseltechnologie für die Elektrifizierung des Antriebssystems von Fahrzeugen. Batteriesysteme und insbesondere Lithium-Ionen-Batteriesysteme können dabei je nach Einsatzspezifikation modular aufgebaut sein und umfassen meist eine Mehrzahl von seriell oder parallel elektrisch verschalteten Batteriezellen.

Ein wesentlicher Aspekt für die erfolgreiche Etablierung dieser Technologie ist unter anderem die Betriebssicherheit der Batteriesysteme, speziell der Lithium-Ionen-Batteriesysteme, die nicht selten mit großen Kapazitäten betrieben werden. Dabei ist es erforderlich, das Batteriesystem innerhalb eines optimalen Temperaturbereichs zu betreiben. Denn die Batterietemperatur hat einen großen Einfluss auf die Leistungsbereitstellung, Alterung, Lebensdauer und Betriebssicherheit des Batteriesystems. Um dies zu gewährleisten, weisen Batteriesysteme meist ein ausgefeiltes thermisches Managementkonzept auf.

Während des Betriebs von Batteriesystemen kann es vorkommen, dass die Temperatur in der Batterie derart ansteigt, dass diese sich nicht mehr durch äußere Kühlsysteme abkühlen lässt. Hauptursache für solche Temperaturverläufe sind interne Kurzschlüsse in der Batterie, hervorgerufen beispielsweise durch physische Deformationen der Batterie oder durch Verunreinigungen bei der Herstellung der Batterie (beispielsweise Beschädigung des Separators durch Partikel). Ein interner Kurzschluss kann weitere elektrochemische irreversible Prozesse in der Batterie in Gang setzen, bei denen Wärme freigesetzt wird (exotherme Reaktionen). Schließlich kann es zu einem so genannten thermischen Durchgehen, einer Art selbstbeschleunigter Überhitzung, kommen, welches zu einem Bersten des Überdrucksicherheitsventils mit Abblasen von toxischen Gasen oder gar zu einem Bersten der Batteriezelle führen kann. Eine andere mögliche Ursache für irreversible Temperaturzunahmen einer Batterie ist eine Überladung der Batterie.

Üblicherweise weisen Batteriesysteme Sicherheitseinrichtungen auf, die der Vermeidung eines thermischen Durchgehens des Batteriesystems dienen. Ziel ist es dabei, die Gefahr einer irreversiblen Überhitzung frühzeitig zu erkennen und gegebenenfalls die Batterie schnell vom restlichen Stromnetz zu trennen. In Batteriezellen mit größerer Speicherkapazität, typischerweise von mehr als 3 Amperestunden, werden beispielsweise Sicherheitseinrichtungen integriert, welche bei einem erhöhten Innendruck, welcher bei einer erhöhten Temperatur in der Batteriezelle entsteht, einen Strom durch die Batteriezelle unterbinden, sogenannte CIDs (Current Interruptive Devices). Diese schützen bei Überlast durch zu hohe Lade- oder Entladeströme und Überlast durch externen Kurzschluss, welche ein thermisches Durchgehen verursachen, nicht aber bei anderen Ursachen, insbesondere bei einem internen Kurzschluss, welcher durch mechanische Deformierung, Partikel oder Dendriten hervorgerufen wird. Ein weiterer gravierender Nachteil derartiger Sicherheitseinrichtungen ist, dass bei deren Auslösung die zur Überwachung der einzelnen Batteriezellen oder zur Ermittlung des Ladezustands eingesetzte Elektronik Schaden nehmen und das Gesamtsystem in einen nicht definierten Zustand geführt werden kann. Ursache für die Schädigung der Elektronik bei Auslösen eines Current Interruptive Devices ist, dass die zugehörige Spannungserfassung beziehungsweise Spannungsüberwachung mit hohen negativen Spannungen beaufschlagt wird, die bei einer in Fahrzeugen eingesetzten Batterie durchaus mehrere Hundert Volt betragen kann. Die eingesetzten Elektronikkomponenten können nur mit erheblichem Aufwand gegen derartige Belastungen geschützt werden. Daher wird aus Wirtschaftlichkeitsgründen in der Regel auf solche Maßnahmen verzichtet.

In Lithium-Ionen-Batteriezellen werden vielmehr neuartige Sicherheitseinrichtungen integriert, welche diese bei ihrem Auslösen intern kurzschließen, was die oben genannten Nachteile überwindet. Gleichzeitig muss eine Batteriezustandserkennung zur Verfügung gestellt werden, welche das Auslösen dieser neuartigen Sicherheitseinrichtungen erkennt, damit das Batteriesystem in einen sicheren Zustand überführt werden kann. Ein Verfahren bzw. eine Vorrichtung aus dem Stand der Technik wird in DE 694 11 232 T2 offenbart.

### Offenbarung der Erfindung

Erfindungsgemäß wird ein Verfahren zur Erkennung einer Auslösung einer Sicherheitseinrichtung, gemäß den Ansprüchen, bereitgestellt. Hierbei ist die Sicherheitseinrichtung einer Batteriezelle zugeordnet und wird ausgelöst, wenn eine sicherheitskritische Situation in der Batteriezelle vorliegt. Zunächst wird ein tatsächlicher zeitlicher Verlauf einer Kenngröße der Batteriezelle erfasst. Gleichzeitig wird ein erwarteter zeitlicher Verlauf der Kenngröße ermittelt, insbesondere unter Verwendung eines Modells. Sodann wird der tatsächliche mit dem erwarteten zeitlichen Verlauf der Kenngröße verglichen. Schließlich wird auf Grundlage des Vergleichs entschieden, ob die Sicherheitseinrichtung ausgelöst worden ist.

Auf diese Weise wird eine Batteriezustandserkennung bereitgestellt, welche das Auslösen einer Sicherheitseinrichtung, welche typischerweise in einer Batteriezelle integriert ist, erkennt und somit ermöglicht, dass ein Batteriemanagementsystem das die Batteriezelle umfassende Batteriesystem in einen sicheren Zustand überführen kann. Im Vergleich zum Stand der Technik, in welchem in den Batteriezellen nach Auslösen einer Sicherheitseinrichtung kein Stromfluss mehr ermöglicht wird, ist das Verfahren auch auf neuartige Sicherheitseinrichtungen anwendbar, welche eine anderweitige Erkennung des Auslösens der Sicherheitseinrichtung erforderlich machen.

Das Verfahren ist somit auf Sicherheitseinrichtungen anwendbar, welche die ihnen zugeordneten Batteriezellen in einer sicherheitskritischen Situation kurzschließen, insbesondere bei einem erhöhten Innendruck oder bei einer mechanischen Deformation der Batteriezelle. Ebenso ist das Verfahren anwendbar auf Sicherheitseinrichtungen, welche die ihnen zugeordneten Batteriezellen in einer sicherheitskritischen Situation überbrücken, insbesondere bei einem erhöhten Innendruck der Batteriezelle. Das erfindungsgemäße Verfahren hat den Vorteil, dass es typischerweise auf der Auswertung von Signalen beruht, welche einer batterieüberwachenden Batteriemanagementeinheit ohnehin vorliegen oder sich mit geringem Aufwand erfassen oder ermitteln lassen.

In der Erfindung ist vorgesehen, dass eine tatsächliche zeitliche Änderung der Kenngröße mit einer erwarteten Änderung der Kenngröße verglichen wird. Besonders bevorzugt ist, dass es sich hierbei um die zeitliche Änderung einer Spannung der Batteriezelle handelt. Hierbei kann entschieden werden, dass die Sicherheitseinrichtung ausgelöst worden ist, wenn die tatsächliche zeitliche Änderung der Spannung der Batteriezelle von der erwarteten zeitlichen Änderung der Spannung erheblich abweicht. Weiter ist bevorzugt, dass die erwartete zeitliche Änderung der Spannung der Batteriezelle unter Verwendung eines Batteriemodells ermittelt wird, in welchem ein durch die Batteriezelle fließender Batteriestrom und/oder eine Temperatur der Batteriezelle berücksichtigt werden. Typischerweise ist das Batteriemodell als Beobachtersystem ausgestaltet, wobei dem Batteriemodell der tatsächliche zeitliche Verlauf der Spannung zugeführt wird.

Weitere Aspekte der Erfindung betreffen eine Batteriemanagementeinheit, in welcher das erfindungsgemäße Verfahren ausführbar ist, sowie eine Batterie, welche die erfindungsgemäße Batteriemanagementeinheit umfasst. Bei der Batterie handelt es sich bevorzugt um eine Lithium-Ionen-Batterie. Bei den im Rahmen der Erfindung wesentlichen Vorrichtungen Batteriezelle, Batteriemanagementeinheit beziehungsweise Batterie kann es sich genauer um eine Akkumulatorzelle, eine Akkumulatormanagementeinheit beziehungsweise einen Akkumulator handeln.

Ein weiterer Aspekt der Erfindung betrifft ein Kraftfahrzeug, welches die erfindungsgemäße Batterie umfasst.

### Zeichnungen

Ausführungsbeispiele der Erfindung werden anhand der Zeichnungen und der nachfolgenden Beschreibung näher erläutert. Es zeigen:
Figur 1 ein Blockschaltbild einer Batteriezustandserkennung gemäß einer ersten Ausführung des erfindungsgemäßen Verfahrens,
Figur 2 ein Blockschaltbild einer Batteriezustandserkennung gemäß einer zweiten Ausführung des erfindungsgemäßen Verfahrens, und
Figur 3 ein Blockschaltbild einer Batteriezustandserkennung gemäß einer dritten Ausführung des erfindungsgemäßen Verfahrens.

### Ausführungsformen der Erfindung

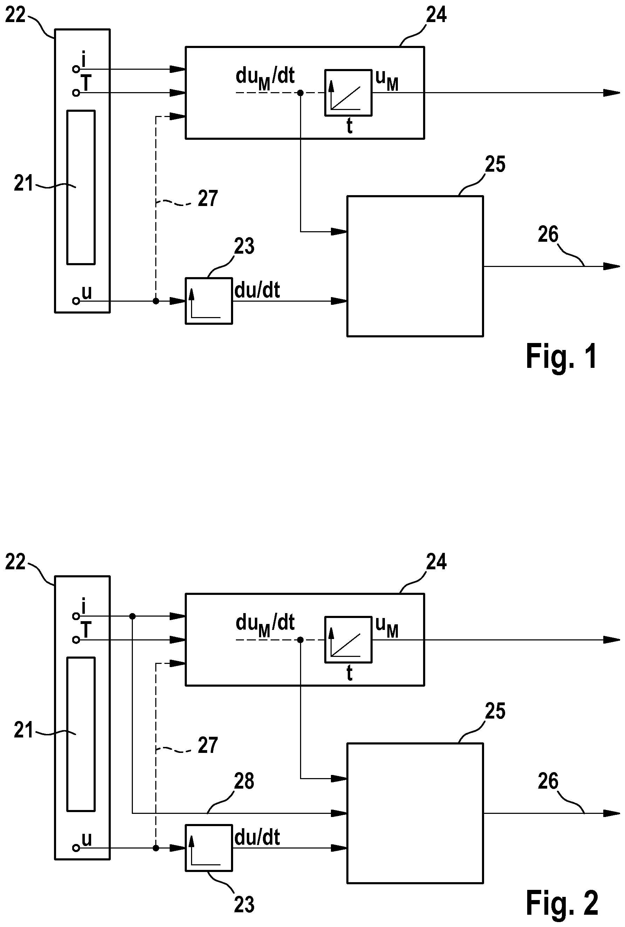

Figur 1 zeigt ein Blockschaltbild einer Batteriezustandserkennung gemäß einer ersten Ausführung des erfindungsgemäßen Verfahrens. Eine Sicherheitseinrichtung 21 ist in einer Batteriezelle 22 integriert und schließt die Batteriezelle 22 in einer sicherheitskritischen Situation kurz, insbesondere bei einem erhöhten Innendruck oder bei einer mechanischen Deformation der Batteriezelle 22. In einer Erfassungseinheit 23 wird fortwährend eine Spannung u der Batteriezelle 22 gemessen und daraus die tatsächliche zeitliche Änderung der Spannung du/dt ermittelt. In einer Modelleinheit 24 wird gleichzeitig eine erwartete zeitliche Änderung der Spannung du_{M}/dt ermittelt. Dies geschieht dadurch, dass der Modelleinheit 24 ein Batteriestrom i und eine Batterietemperatur T zugeführt werden. Hieraus berechnet die Modelleinheit 24 den erwarteten zeitlichen Verlauf der Spannung u_{M} der Batteriezelle 22 sowie deren zeitliche Änderung du_{M}/dt. Die Modelleinheit 24 ist insbesondere als Beobachtereinheit ausgeführt, welcher fortwährend die tatsächliche Spannung u der Batteriezelle 22 zugeführt wird. Hierdurch wird erreicht, dass das berechnete Batteriemodell fortwährend aktualisiert werden kann, indem der erwartete zeitliche Verlauf der Spannung an den tatsächlichen Verlauf angeglichen wird.

Die von der Erfassungseinheit 23 ermittelte tatsächliche zeitliche Änderung der Spannung du/dt sowie die von der Modelleinheit 24 berechnete erwartete zeitliche Änderung der Spannung du_{M}/dt werden einer Auswertungseinheit 25 zugeführt. Die Auswertungseinheit 25 vergleicht fortwährend die beiden Werte miteinander und erkennt eine Auslösung der Sicherheitseinrichtung (26), wenn die tatsächliche zeitliche Änderung der Spannung du/dt der Batteriezelle 22 erheblich kleiner als die erwartete zeitliche Änderung du_{M}/dt der Spannung der Batteriezelle 22 ist, da auf diese Weise auf einen Kurzschluss in der Batteriezelle 22 geschlossen werden kann.

Figur 2 zeigt ein Blockschaltbild einer Batteriezustandserkennung gemäß einer zweiten Ausführung des erfindungsgemäßen Verfahrens. Im Gegensatz zu der in Figur 1 dargestellten Ausführungsform ist bei der in Figur 2 dargestellten Ausführungsform vorgesehen, dass der Auswertungseinheit 25 zusätzlich ein Signal für den Batteriestrom i zugeführt wird (28). Hierdurch ist eine Erhöhung der Robustheit der Auswertung in der Auswertungseinheit 25 möglich, da der Batteriestrom i zusätzliche Informationen über den Zustand der Batteriezelle 22 liefert. Beispielsweise ist bei einer Ladung der Batteriezelle 22 eine positive zeitliche Änderung der Spannung du_{M}/dt der Batteriezelle 22 zu erwarten. Tritt aber an der Batteriezelle 22 eine negative zeitliche Änderung der Spannung du/dt auf, kann durch die Auswertungseinheit 25 auf einen Kurzschluss und somit ein Auslösen der Sicherheitseinrichtung 21 geschlossen werden.

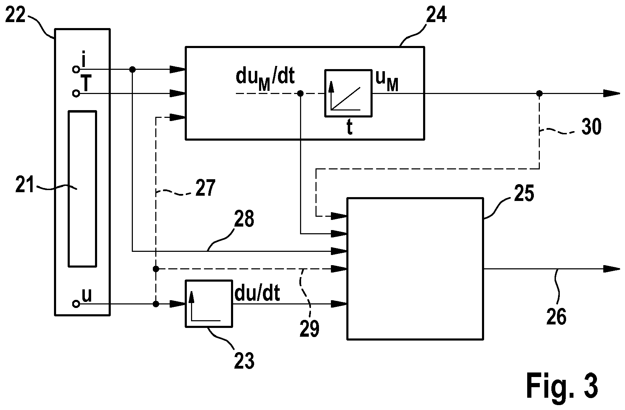

Figur 3 zeigt ein Blockschaltbild einer Batteriezustandserkennung gemäß einer dritten Ausführung des erfindungsgemäßen Verfahrens. Die in Figur 3 dargestellte dritte Ausführungsform der Erfindung unterscheidet sich von der in Figur 2 dargestellten zweiten Ausführungsform der Erfindung dadurch, dass der Auswerteeinheit 25 zusätzlich fortwährend die tatsächliche Spannung u (29) sowie die erwartete Spannung u_{M} (30) zugeführt werden. Durch Auswertung der Informationen über tatsächliche und erwartete Spannung der Batteriezelle 22, insbesondere der Differenz der genannten Größen, kann die Robustheit der Vorhersage einer Auslösung der Sicherheitseinrichtung 21 erheblich verbessert werden. Tritt beispielsweise in der Batteriezelle 22 ein sehr niedrigohmiger Kurzschluss auf, bricht die Spannung der Batteriezelle 22 sofort stark ein. Hierdurch wird kurzzeitig ein hoher negativer Wert der tatsächlichen zeitlichen Änderung der Batteriespannung du/dt verursacht. Ohne zusätzliche Informationen über die Spannung der Batteriezelle 22 könnte die Auswerteeinheit dies als Störsignal auffassen. Aus der Differenz der beiden Spannungen u und u_{M} kann aber ein Kurzschluss einfach erkannt werden und somit ein Auslösen der Sicherheitseinrichtung 21.

Die in den Figuren 1 bis 3 dargestellten Ausführungsformen der Erfindung sind mit leichten Modifikationen auch für den Fall einsetzbar, dass die Sicherheitseinrichtung 21 in einer sicherheitskritischen Situation, insbesondere bei einem erhöhten Innendruck der Batteriezelle 22, diese überbrückt. Im Unterschied zum Kurzschluss wird die Batteriezelle 22 nach einem Auslösen der Sicherheitseinrichtung 21 in diesem Fall somit nicht entladen. Die tatsächliche Spannung u der Batteriezelle 22 ändert sich somit nicht mehr oder nur geringfügig. Die tatsächliche zeitliche Änderung der Spannung du/dt der Batteriezelle 22 weist somit den Wert 0 oder zumindest einen dem Betrag nach sehr kleinen Wert auf. Falls dagegen die erwartete zeitliche Änderung der Spannung du_{M}/dt der Batteriezelle 22 aufgrund eines Lade- oder Entladevorgangs nennenswerte Beträge aufweist, kann wiederum auf das Auslösen der Sicherheitseinrichtung 21 geschlossen werden.

## Patentansprüche

1. Verfahren zur Erkennung einer Auslösung einer Sicherheitseinrichtung (21) mittels einer Batteriemanagementeinheit, wobei die Sicherheitseinrichtung (21) in einer Batteriezelle (22) integriert ist und ausgelöst wird, wenn eine sicherheitskritische Situation in der Batteriezelle (22) vorliegt, **dadurch gekennzeichnet, dass** die Batteriemanagementeinheit eine Erfassungseinheit (23), eine Modelleinheit (24) und eine Auswerteeinheit (25) aufweist,
wobei das Verfahren folgende Verfahrensschritte umfasst:
- Erfassen eines tatsächlichen zeitlichen Verlaufs einer Kenngröße der Batteriezelle (22) mittels der Erfassungseinheit (23);
- Ermitteln eines erwarteten zeitlichen Verlaufs der Kenngröße mittels der Modelleinheit (24), insbesondere unter Verwendung eines Modells;
- Vergleichen des tatsächlichen mit dem erwarteten zeitlichen Verlauf der Kenngröße mittels der Auswerteeinheit (25); und
- Entscheiden auf Grundlage des Vergleichs mittels der Auswerteeinheit (25), ob die Sicherheitseinrichtung (21) ausgelöst worden ist (26).

2. Verfahren nach Anspruch 1, wobei ein die Batteriezelle (22) umfassendes Batteriesystem in einen sicheren Zustand überführt wird, wenn eine Auslösung der Sicherheitseinrichtung (21) erkannt worden ist.

3. Verfahren nach Anspruch 1 oder 2, wobei die Sicherheitseinrichtung (21) die Batteriezelle (22) in einer sicherheitskritischen Situation kurzschließt, insbesondere bei einem erhöhten Innendruck oder bei einer mechanischen Deformation der Batteriezelle (22).

4. Verfahren nach Anspruch 1 oder 2, wobei die Sicherheitseinrichtung (21) die Batteriezelle (22) in einer sicherheitskritischen Situation überbrückt, insbesondere bei einem erhöhten Innendruck der Batteriezelle (22).

5. Verfahren nach einem der vorangehenden Ansprüche, wobei eine tatsächliche zeitliche Änderung der Kenngröße mit einer erwarteten Änderung der Kenngröße verglichen wird (25).

6. Verfahren nach Anspruch 5, wobei die tatsächliche zeitliche Änderung einer Spannung der Batteriezelle (du/dt) mit der erwarteten zeitlichen Änderung der Spannung der Batteriezelle (du_{M}/dt) verglichen wird (25).

7. Verfahren nach Anspruch 6, wobei entschieden wird, dass die Sicherheitseinrichtung (21) ausgelöst worden ist (26), wenn die tatsächliche zeitliche Änderung der Spannung (du/dt) der Batteriezelle (22) von der erwarteten zeitlichen Änderung der Spannung (du_{M}/dt) erheblich abweicht.

8. Verfahren nach Anspruch 6 oder 7, wobei die erwartete zeitliche Änderung der Spannung (du_{M}/dt) der Batteriezelle (22) unter Verwendung eines Batteriemodells ermittelt wird, in welchem ein durch die Batteriezelle (22) fließender Batteriestrom (i) und/oder eine Temperatur (T) der Batteriezelle (22) berücksichtigt werden.

9. Verfahren nach einem der Ansprüche 1 bis 8, wobei die Modelleinheit (24) als Beobachtersystem ausgestaltet ist, wobei der Modelleinheit (24) der tatsächliche zeitliche Verlauf der Spannung (u) zugeführt wird (27).

10. Batteriemanagementeinheit, **dadurch gekennzeichnet, dass** die Batteriemanagementeinheit dazu ausgelegt ist, ein Verfahren nach einem der vorangehenden Ansprüche auszuführen.

11. Batterie mit mindestens einer Batteriezelle (22), mindestens einer Sicherheitseinrichtung (21), welche der Batteriezelle (22) zugeordnet ist und auslösbar ist, wenn eine sicherheitskritische Situation in der Batteriezelle (22) vorliegt und mit einer Batteriemanagementeinheit nach Anspruch 10.

12. Kraftfahrzeug, insbesondere elektrisches Kraftfahrzeug, umfassend eine Batterie nach Anspruch 11.

## Claims

1. Method for identifying triggering of a safety device (21) by means of a battery management unit, wherein the safety device (21) is integrated in a battery cell (22) and is triggered when there is a safety-critical situation in the battery cell (22), **characterized in that**
the battery management unit has a detection unit (23), a model unit (24) and an evaluation unit (25),
wherein the method comprises the following method steps:
- detecting an actual time profile of a characteristic variable of the battery cell (22) by means of the detection unit (23);
- determining an expected time profile of the characteristic variable by means of the model unit (24), in particular using a model;
- comparing the actual time profile of the characteristic variable with the expected time profile of said characteristic variable by means of the evaluation unit (25); and
- making a decision, on the basis of the comparison by means of the evaluation unit (25), as to whether the safety device (21) has been triggered (26).

2. Method according to Claim 1, wherein a battery system, which comprises the battery cell (22), is moved to a safe state when triggering of the safety device (21) has been identified.

3. Method according to Claim 1 or 2, wherein the safety device (21) short-circuits the battery cell (22) in a safety-critical situation, in particular in the case of an elevated internal pressure or in the case of a mechanical deformation of the battery cell (22).

4. Method according to Claim 1 or 2, wherein the safety device (21) bridges the battery cell (22) in a safety-critical situation, in particular in the case of an elevated internal pressure in the battery cell (22).

5. Method according to one of the preceding claims, wherein an actual change in the characteristic variable over time is compared (25) with an expected change in the characteristic variable.

6. Method according to Claim 5, wherein the actual change in a voltage of the battery cell (du/dt) over time is compared (25) with the expected change in the voltage of the battery cell (du_{M}/dt) over time.

7. Method according to Claim 6, wherein a decision is made that the safety device (21) has been triggered (26) when the actual change in the voltage (du/dt) of the battery cell (22) over time deviates considerably from the expected change in the voltage (du_{M}/dt) over time.

8. Method according to Claim 6 or 7, wherein the expected change in the voltage (du_{M}/dt) of the battery cell (22) over time is determined using a battery module in which a battery current (i) which flows through the battery cell (22) and/or a temperature (T) of the battery cell (22) are/is taken into consideration.

9. Method according to one of Claims 1 to 8, wherein the model unit (24) is configured as an observer system, wherein the actual time profile of the voltage (u) is supplied (27) to the model unit (24).

10. Battery management unit, **characterized in that** the battery management unit is designed to execute a method according to one of the preceding claims.

11. Battery comprising at least one battery cell (22), at least one safety device (21) which is associated with the battery cell (22) and can be triggered when there is a safety-critical situation in the battery cell (22), and comprising a battery management unit according to Claim 10.

12. Motor vehicle, in particular electric motor vehicle, comprising a battery according to Claim 11.

## Revendications

1. Procédé, destiné à identifier un déclenchement d'un système de sécurité (21) au moyen d'une unité gestionnaire de batterie, le système de sécurité (21) étant intégré dans une cellule de batterie (22) et étant déclenché en présence d'une situation critique en matière de sécurité dans la cellule de batterie (22), **caractérisé en ce que** l'unité gestionnaire de batterie comporte une unité de détection (23), une unité de modélisation (24) et une unité d'évaluation (25),
le procédé comprenant les étapes de procédé suivantes, consistant à :
- détecter une courbe dans le temps effective d'une grandeur caractéristique de la cellule de batterie (22) au moyen de l'unité de détection (23) ;
- déterminer une courbe dans le temps attendue de la grandeur caractéristique au moyen de l'unité de modélisation (24), notamment en utilisant un modèle ;
- comparer la courbe dans le temps effective avec la courbe dans le temps attendue de la grandeur caractéristique au moyen de l'unité d'évaluation (25) ; et
- décider sur la base de la comparaison, au moyen de l'unité d'évaluation (25) si le système de sécurité (21) a été déclenché (26) .

2. Procédé selon la revendication 1, un système de batterie comprenant la cellule de batterie (22) étant passé dans un état de sécurité lorsqu'un déclenchement du système de sécurité (21) a été identifié.

3. Procédé selon la revendication 1 ou 2, le système de sécurité (21) court-circuitant la cellule de batterie (22) dans une situation critique en matière de sécurité, notamment en présence d'une pression intérieure élevée ou en présence d'une déformation mécanique de la cellule de batterie (22) .

4. Procédé selon la revendication 1 ou 2, le système de sécurité (21) pontant la cellule de batterie (22) dans une situation critique en matière de sécurité, notamment en présence d'une pression intérieure élevée de la cellule de batterie (22).

5. Procédé selon l'une quelconque des revendications précédentes, une modification dans le temps effective de la grandeur caractéristique étant comparée (25) avec une modification attendue de la grandeur caractéristique.

6. Procédé selon la revendication 5, la modification dans le temps effective d'une tension de la cellule de batterie (du/dt) étant comparée (25) avec la modification dans le temps attendue de la tension de la cellule de batterie (du_{M}/dt).

7. Procédé selon la revendication 6, lors duquel il est décidé que le système de sécurité (21) a été déclenché (26), si la modification dans le temps effective de la tension (du/dt) de la cellule de batterie (22) diverge considérablement de la modification dans le temps attendue de la tension (du_{M/}dt).

8. Procédé selon la revendication 6 ou 7, la modification dans le temps attendue de la tension (du_{M}/dt) de la cellule de batterie (22) étant déterminée en utilisant un modèle de batterie dans lequel un courant de batterie (i) circulant à travers la cellule de batterie (22) et/ou une température (T) de la cellule de batterie (22) sont pris en compte.

9. Procédé selon l'une quelconque des revendications 1 à 8, l'unité de modélisation (24) étant conçue sous la forme d'un système d'observation, la courbe dans le temps effective de la tension (u) étant amenée (27) à l'unité de modélisation (24).

10. Unité gestionnaire de batterie, **caractérisée en ce que** l'unité gestionnaire de batterie est conçue pour réaliser un procédé selon l'une quelconque des revendications précédentes.

11. Batterie, pourvue d'au moins une cellule de batterie (22), d'au moins un système de sécurité (21), lequel est affecté à la cellule de batterie (22) et est déclenchable en présence d'une situation critique en matière de sécurité dans la cellule de batterie (22) et pourvue d'une unité gestionnaire de batterie selon la revendication 10.

12. Véhicule automobile, notamment véhicule automobile électrique, comprenant une batterie selon la revendication 11.
